# EUROPEAN PATENT APPLICATION

(11) **EP 4 656 969 A1**
(43) Date of publication of application: **03.12.2025**
(21) Application number: 24763760.6
(22) Date of filing: 22.02.2024
(51) Int. Cl.: F25B 13/00, F25B 1/00, F25B 41/26, F25B 49/02, H01L 21/3065

(54) **TEMPERATURE REGULATION DEVICE FOR SEMICONDUCTOR MANUFACTURING DEVICE**

(30) Priority: 02.03.2023 JP 2023031758
(71) Applicant: SMC Corporation, Tokyo 104-0031 (JP)
(72) Inventor: NIIMI, Hirohito, Ibaraki 3002493 (JP); SAKAGUCHI, Tetsuo, Ibaraki 3002493 (JP); TAKEI, Shinpei, Ibaraki 3002493 (JP)
(74) Representative: Keil & Schaafhausen Patentanwälte PartGmbB
(86) International application number: PCT/JP2024/006406
(87) International publication number: WO 2024/181279

(57) **Abstract**

[Object] To provide a temperature regulation device for semiconductor manufacturing device capable of performing temperature regulation of a thermal load more responsively and rapidly in a wide temperature range from the low temperature side to the high temperature side and also capable of suppressing environmental impact.

[Solution] The refrigeration circuit 1A, 1B is constituted by a compressor 2; a delivery passage 3 through which refrigerant is delivered from the compressor; a return passage 4 through which refrigerant after temperature regulation is returned to the compressor; first and second circulation passages 5 and 6 through which refrigerant is supplied to a thermal load W in a circulating manner; a switching circuit 10A, 10B that mutually switches, between the first and second circulation passages, a circulation passage through which refrigerant is delivered to a thermal load and a circulation passage through which refrigerant is received from a thermal load by changing a communication state in which the circulation passages are in communication with the delivery passage and the return passage; a first expansion valve 5c provided in the first circulation passage; and a heat exchanger 7 connected between the first circulation passage and the switching circuit.

## Description

### Technical Field

The present invention relates to a temperature regulation device for regulating the temperature of a thermal load, in particular, in a semiconductor manufacturing device to a predetermined temperature.

### Background Art

As a temperature regulation device for regulating a thermal load in a semiconductor manufacturing device or the like to a predetermined temperature, a device that regulates a thermal load to a predetermined temperature by controlling constant temperature liquid that flows in a constant-temperature-liquid circulation circuit to a set temperature through heat exchange or the like with refrigerant that flows in a refrigeration circuit and supplying the constant temperature liquid whose temperature is controlled to the thermal load in a circulating manner is widely known as disclosed in, for example, PTL 1.

Incidentally, in these days, due to micromachining in semiconductor processes, improvement in accuracy and improvement in production efficiency in semiconductor manufacturing devices are matters requiring immediate attention while temperature control of constant temperature liquid is performed through heat exchange with refrigerant in a refrigeration circuit in a constant-temperature-liquid circulation device, such as that described above, in the related art. Therefore, when a set temperature of constant temperature liquid is changed, a certain length of time is required for the constant temperature liquid to reach a state of being stably controlled at a set temperature after the change. Thus, development of a temperature regulation device capable of performing temperature regulation of a thermal load more responsively and rapidly has been desired.

Further, since temperature regulation in a wider range from the low temperature side to the high temperature side is required in semiconductor manufacturing devices, fluorinated liquid has been suitably used as constant temperature liquid in temperature regulation devices in the related art. However, it is desirable to suppress the use of the fluorinated liquid as much as possible in consideration of environmental impact.

### Citation List

### Patent Literature

PTL 1: Japanese Unexamined Patent Application Publication No. 4582473

### Summary of Invention

### Technical Problem

Thus, a technical object of the invention of the present application is to provide a temperature regulation device for semiconductor manufacturing device capable of not only performing temperature regulation of a thermal load more responsively and rapidly in a wide temperature range from the low temperature side to the high temperature side but also suppressing environmental impact.

### Solution to Problem

To solve the aforementioned technical problem, the present invention is temperature regulation device for semiconductor manufacturing device, the temperature regulation device being for regulating a temperature of a thermal load in a semiconductor manufacturing device to a predetermined temperature, the temperature regulation device including a refrigeration circuit including a refrigeration compressor that generates refrigerant having high temperature and high pressure, a delivery passage connected to the compressor and through which refrigerant is delivered from the compressor, a return passage connected to the compressor and through which refrigerant is returned to the compressor, a first circulation passage and a second circulation passage each having a connection port to be connected to a thermal load and each being for supplying refrigerant to a thermal load in a circulating manner, a switching circuit that mutually switches, between the first and second circulation passages, a circulation passage for delivering refrigerant to a thermal load and a circulation passage for receiving refrigerant from a thermal load by changing a communication state in which the first and second circulation passages are in communication with the delivery passage and the return passage, and a heat exchanger including a refrigerant heat exchange passage that connects the first circulation passage to the switching circuit; a heat-dissipating-water circuit including a heat-dissipating-water heat exchange passage through which heat-dissipating water that exchanges heat with refrigerant in the refrigerant heat exchange passage in the heat exchanger flows and a heat-dissipating-water supply/drainage passage through which heat-dissipating water is supplied to and drained from the heat-dissipating-water heat exchange passage; and a controller including a processor that controls the refrigeration circuit and the heat-dissipating-water circuit, in which the first circulation passage includes an expansion valve that adiabatically expands refrigerant, and in which the processor controls the switching circuit such that, when temperature regulation of a thermal load is performed by cooling, refrigerant is delivered to a thermal load from a connection port of the first circulation passage and refrigerant from a thermal load is received through a connection port of the second circulation passage and conversely, when temperature regulation of a thermal load is performed by heating, refrigerant is delivered to a thermal load from a connection port of the second circulation passage and refrigerant from a thermal load is received through a connection port of the first circulation passage.

Here, in the present invention, preferably, the switching circuit includes a first connection passage including a first flow-rate control valve and connecting the delivery passage to the heat exchanger, a second connection passage including a second flow-rate control valve and connecting the delivery passage to the second circulation passage, a third connection passage including a third flow-rate control valve and connecting the second circulation passage to the return passage, and a fourth connection passage including a fourth flow-rate control valve and connecting the heat exchanger to the return passage, and the processor controls the first to fourth flow-rate control valves such that, when temperature regulation of a thermal load is switched from heating to cooling, refrigerant is delivered to a thermal load from a connection port of the first circulation passage by continuously decreasing an opening degree of the second flow-rate control valve and an opening degree of the fourth flow-rate control valve and continuously increasing an opening degree of the first flow-rate control valve and an opening degree of the third flow-rate control valve and, conversely, when temperature regulation of a thermal load is switched from cooling to heating, refrigerant is delivered to a thermal load from a connection port of the second circulation passage by continuously decreasing an opening degree of the first flow-rate control valve and an opening degree of the third flow-rate control valve and continuously increasing an opening degree of the second flow-rate control valve and an opening degree of the fourth flow-rate control valve.

Then, in the present invention, preferably, the return passage includes a first temperature sensor and a first pressure sensor, and the heat-dissipating-water supply/drainage passage includes a heat-dissipating-water control valve, and the processor calculates a degree of superheat of refrigerant based on a temperature of refrigerant detected by the first temperature sensor and a pressure of refrigerant detected by the first pressure sensor and controls the heat-dissipating-water control valve such that, in a state in which temperature regulation of a thermal load is performed by heating, when a degree of superheat of the refrigerant is lower than a first set superheat degree, an opening degree of the heat-dissipating-water control valve is increased and, conversely, when a degree of superheat of the refrigerant is higher than a second set superheat degree that is equal to or greater than the first set superheat degree, an opening degree of the heat-dissipating-water control valve is decreased.

In addition, preferably, the delivery passage includes a second pressure sensor, the heat-dissipating-water supply/drainage passage includes a heat-dissipating-water control valve, and the processor controls the heat-dissipating-water control valve such that, in a state in which temperature regulation of a thermal load is performed by cooling, when a pressure of refrigerant detected by the second pressure sensor is higher than a first set pressure, an opening degree of the heat-dissipating-water control valve is increased and, conversely, when a pressure of the refrigerant is lower than a second set pressure that is equal to or less than the first set pressure, an opening degree of the heat-dissipating-water control valve is decreased.

Further, in the present invention, preferably, a cooling passage through which refrigerant for compressor-cooling is supplied to the compressor is branched from the first circulation passage and connected to the compressor, and, here, more preferably, the cooling passage includes a first branch passage that is branched from a location closer than the expansion valve to the heat exchanger and that includes a first opening/closing control valve, a second branch passage that is branched from a location closer than the expansion valve to a connection port of the first circulation passage and that includes a second opening/closing control valve, and an injection valve that adiabatically expands refrigerant, the first branch passage and the second branch passage being connected to the compressor through the injection valve, and the processor controls the first and second opening/closing control valves such that, in a state in which temperature regulation of a thermal load is performed by cooling, the first opening/closing control valve is opened and the second opening/closing control valve is closed and, conversely, in a state in which temperature regulation of a thermal load is performed by heating, the first opening/closing control valve is closed and the second opening/closing control valve is opened.
In addition, further preferably, the delivery passage includes a second temperature sensor that detects a temperature of refrigerant that is delivered from the compressor, and the processor controls the injection valve such that, when a temperature of refrigerant detected by the second temperature sensor is higher than a first set temperature, an opening degree of the injection valve is increased and, conversely, when a temperature of the refrigerant is lower than a second set temperature that is equal to or less than the first set temperature, an opening degree of the injection valve is decreased.

In the present invention, preferably, the first and second circulation passages each include an emergency shutoff valve that intercepts, in an emergency, inflow and outflow of refrigerant from the connection ports of the circulation passages, and the emergency shutoff valve is a solenoid valve of a normal close type.
In addition, preferably, the temperature regulation device includes a third temperature sensor for detecting a temperature of a thermal load, and the processor controls the expansion valve such that, in a state in which temperature regulation of a thermal load is performed by cooling, when a temperature of a thermal load detected by the third temperature sensor is higher than a first thermal-load set temperature, an opening degree of the expansion valve is increased and, conversely, when a temperature of the thermal load is lower than a second thermal-load set temperature that is equal to or less than the first thermal-load set temperature, an opening degree of the expansion valve is decreased.
Further, preferably, the return passage includes a first temperature sensor and a first pressure sensor, and the processor calculates a degree of superheat of refrigerant based on a temperature of refrigerant detected by the first temperature sensor and a pressure of refrigerant detected by the first pressure sensor and controls the expansion valve such that, in a state in which temperature regulation of a thermal load is performed by heating, when a degree of superheat of the refrigerant is lower than a third set superheat degree, an opening degree of the expansion valve is and, conversely, when a degree of superheat of the refrigerant is higher than a fourth set that is equal to or greater than the third set superheat degree, an opening degree of the expansion valve is .

### Advantageous Effects of Invention

With the temperature regulation device for semiconductor manufacturing device according to the present invention, since it is possible, by selectively supplying refrigerant whose temperature is controlled to low temperature or high temperature by a refrigeration circuit to a thermal load of a semiconductor manufacturing device directly, to perform temperature regulation of the thermal load, it is possible to not only perform temperature regulation of a thermal load more responsively and rapidly in a wide temperature range from the low temperature side to the high temperature side but also possible to suppress environmental impact as much as possible.

### Brief Description of Drawings

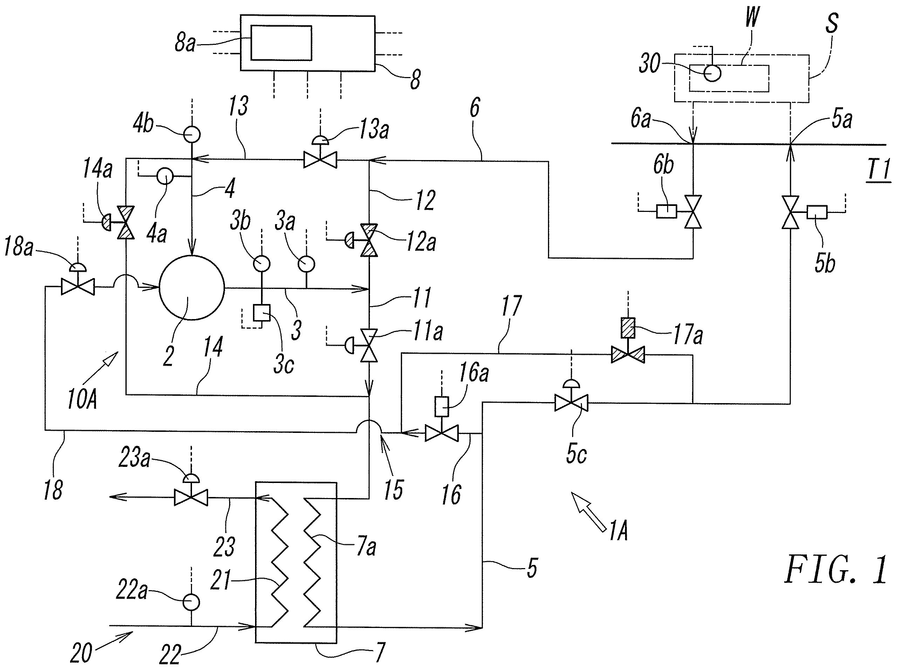

[Fig. 1] Fig. 1 is a circuit diagram of a temperature regulation device for semiconductor manufacturing device according to a first embodiment of the present invention and illustrates a state in which temperature regulation of a thermal load of a semiconductor manufacturing device is performed by cooling.

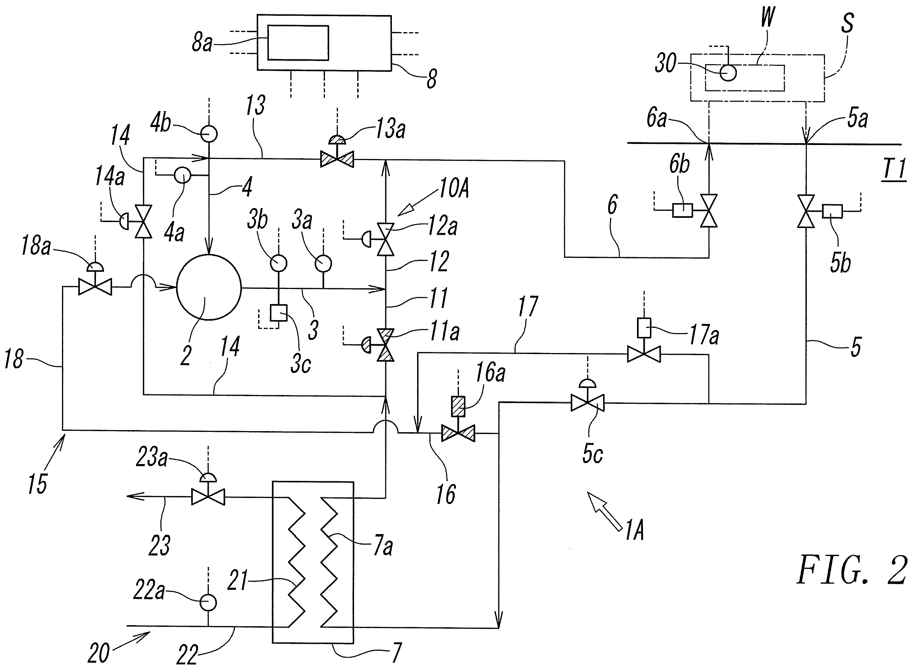

[Fig. 2] Fig. 2 is a circuit diagram of a temperature regulation device for semiconductor manufacturing device according to the first embodiment of the present invention and illustrates a state in which temperature regulation of a thermal load of a semiconductor manufacturing device is performed by heating.

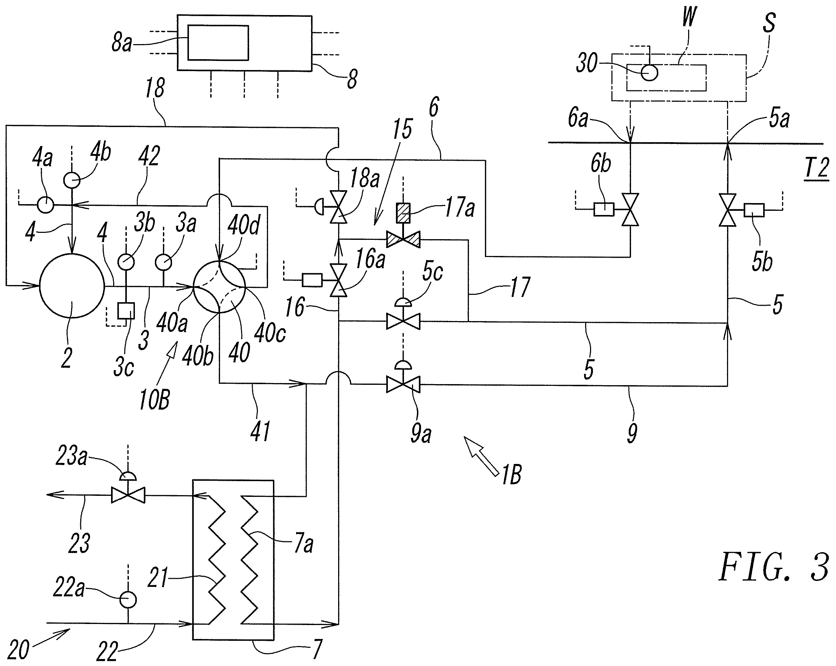

[Fig. 3] Fig. 3 is a circuit diagram of a temperature regulation device for semiconductor manufacturing device according to a second embodiment of the present invention and illustrates a state in which temperature regulation of a thermal load of a semiconductor manufacturing device is performed by cooling.

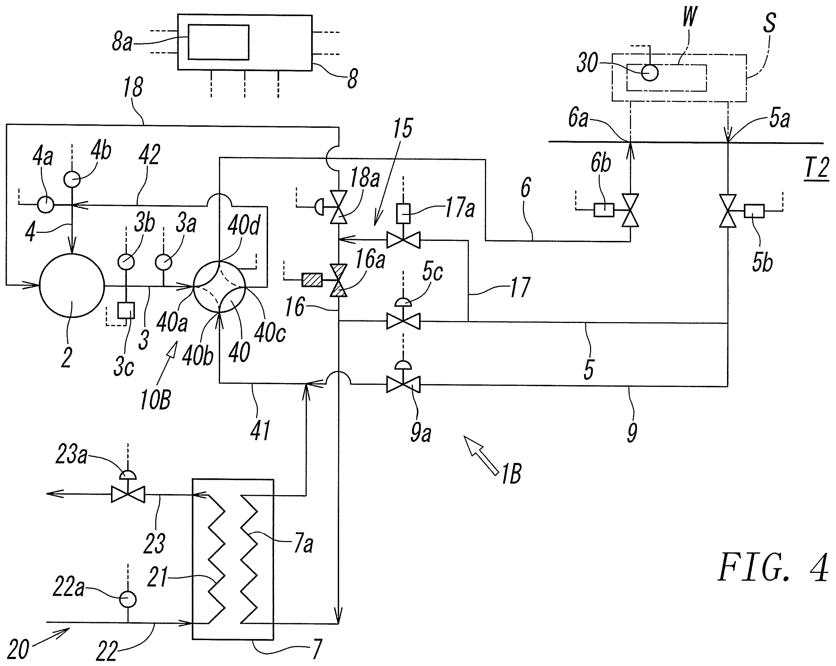

[Fig. 4] Fig. 4 is a circuit diagram of a temperature regulation device for semiconductor manufacturing device according to the second embodiment of the present invention and illustrates a state in which temperature regulation of a thermal load of a semiconductor manufacturing device is performed by heating.

### Description of Embodiments

Fig. 1 and Fig. 2 illustrate a first embodiment of a temperature regulation device for semiconductor manufacturing device according to the present invention. This temperature regulation device T1 is a device for performing regulation of temperature (hereinafter simply referred to as "temperature regulation") of a thermal load W of, for example, a semiconductor-wafer placement table or the like in a semiconductor manufacturing device S by cooling or heating.

In addition, the temperature regulation device T1 includes a refrigeration circuit 1A for supplying temperature-regulated refrigerant to the thermal load W of the semiconductor manufacturing device S, which is a temperature regulation target, in a circulating manner; a heat-dissipating-water circuit 20 for supplying heat-dissipating water, which is to be caused to exchange heat with refrigerant in the refrigeration circuit 1A, to a heat exchanger 7 provided in the refrigeration circuit 1A; and a controller 8 including a processor 8a that controls the refrigeration circuit and the heat-dissipating-water circuit 20. Here, as the refrigerant, refrigerant whose temperature can be controlled in a wide temperature range from low temperature to high temperature is suitably used.

The refrigeration circuit 1A includes a refrigeration compressor 2 that generates gas-phase refrigerant having high temperature and high pressure; a delivery passage 3 connected at one end to the compressor 2 and through which refrigerant generated in the compressor 2 is delivered from the compressor 2; a return passage 4 connected at one end to the compressor 2 and through which refrigerant that is after temperature regulation and that is returned from the thermal load W is returned to the compressor 2; a first circulation passage 5 and a second circulation passage 6 that have, at one end thereof, connection ports 5a and 6a for connection to the thermal load W, respectively, and that are for supplying refrigerant to the thermal load W through the connection ports 5a and 6a in a circulating manner; a switching circuit 10A that mutually switches, between the first and second circulation passages 5 and 6, a circulation passage for delivering refrigerant to the thermal load W and a circulation passage for receiving refrigerant from the thermal load W by changing a communication state in which the first and second circulation passages 5 and 6 are in communication with the delivery passage 3 and the return passage 4; and the heat exchanger 7 including a refrigerant heat exchange passage 7a that connects the first circulation passage 5 to the switching circuit 10A.

In addition, the first passage 5 is provided with a first expansion valve 5c that adiabatically expands refrigerant that flows in the passage. The first expansion valve 5c is electrically connected to the controller 8 so that the opening degree thereof can be controlled by the processor 8a of the controller 8.

In addition, the refrigeration circuit 1A is provided with a cooling passage 15 through which refrigerant for cooling is supplied to the compressor 2, and the cooling passage 15 is branched from the first circulation passage 5 and connected to the compressor 2.

The heat-dissipating-water circuit 20 allows room-temperature tap water or the like to flow as heat-dissipating water therethrough and includes a heat-dissipating-water heat exchange passage 21 through which heat is exchanged in the heat exchanger 7 between refrigerant in the refrigerant heat exchange passage 7a and the heat-dissipating water, and heat-dissipating-water supply/drainage passages 22 and 23 through which the heat-dissipating water is supplied to or drained from the heat-dissipating-water heat exchange passage 21.

According to the temperature regulation device T1 having such a configuration, when the thermal load W is to be cooled by controlling the switching circuit 10A by the processor 8a and changing the communication state in which the first and second circulation passages 5 and 6 are in communication with the delivery passage 3 and the return passage 4, as illustrated in Fig. 1, refrigerant discharged from the compressor 2 is cooled in the heat exchanger 7 as a condenser through the delivery passage 3, is adiabatically expanded at the first expansion valve 5c, and is supplied as refrigerant for cooling to the thermal load W from the connection port 5a of the first circulation passage 5. Then, refrigerant after temperature regulation of the thermal load W is received from the connection port 6a of the second circulation passage 6 and can be returned to the compressor 2 through the return passage 4.

Conversely, when the thermal load W is to be heated, as illustrated in Fig. 2, refrigerant discharged from the compressor 2 is supplied to the thermal load W as refrigerant for heating from the connection port 6a of the second circulation passage 6 through the delivery passage 3. Then, refrigerant after temperature regulation of the thermal load W is received from the connection port 5a of the first circulation passage 5, is adiabatically expanded in the first expansion valve 5c, is heated at the heat exchanger 7 as an evaporator, and can be returned to the compressor 2 through the return passage 4.

Note that such switching control of the switching circuit 10A may be executed by a switch signal from the semiconductor manufacturing device S and may be executed on the basis of results of detection by various types of temperature sensors and pressure sensors provided at the temperature regulation device T1 or the thermal load W.

More specifically describing, the switching circuit 10A includes a first connection passage 11 that connects another end of the delivery passage 3 to one end of the refrigerant heat exchange passage 7a in the heat exchanger 7, a second connection passage 12 that connects the other end of the delivery passage 3 to another end of the second circulation passage 6, a third connection passage 13 that connects the other end of the second circulation passage 6 to another end of the return passage 4, and a fourth connection passage 14 that connects the one end of the refrigerant heat exchange passage 7a in the heat exchanger 7 to the other end of the return passage 4, and these four connection passages form the switching circuit 10A by being connected in an annular shape.

Here, the delivery passage 3 includes a second temperature sensor 3a that detects a temperature of refrigerant delivered from the compressor 2, a second pressure sensor 3b that detects a pressure of the refrigerant, and a high-pressure shutoff pressure switch 3c that detects that the pressure of the refrigerant has reached a threshold of the high pressure side and stops operation of the temperature regulation device T1. The return passage 4 includes a first temperature sensor 4a that detects a temperature of refrigerant that is to be returned to the compressor 2 after being supplied for temperature regulation of the thermal load W, and a first pressure sensor 4b that detects a pressure of the refrigerant. Then, the first and second temperature sensors 4a and 3a, the first and second pressure sensors 4b and 3b, and the high-pressure shutoff pressure switch 3c are all electrically connected to the controller.

Further, a third temperature sensor 30 for detecting a temperature of the thermal load W is attached to the thermal load W of the semiconductor manufacturing device S, and the third temperature sensor 30 is, for example, electrically connected to the controller 8 so that a temperature detected by the temperature sensor 30 is transmitted to the controller 8.

In addition, the first connection passage 11 of the switching circuit 10A includes a first flow-rate control valve 11a, the second connection passage 12 includes a second flow-rate control valve 12a, the third connection passage 13 includes a third flow-rate control valve 13a, and the fourth connection passage 14 includes a fourth flow-rate control valve 14a. Then, these flow-rate control valves 11a, 12a, 13a, and 14a are electrically connected to the controller 8, the opening degrees thereof are controlled by the processor 8a of the controller 8, and, consequently, the flow rate of refrigerant that flows in each of the connection passages 11, 12, 13, and 14 can be individually and continuously changed.

The cooling passage 15 includes a first branch passage 16 that is branched from a location in the first circulation passage 5, the location being closer to the heat exchanger 7 (closer to the other end) than the first expansion valve 5c, a second branch passage 17 that is branched from a location closer to the connection port 5a of the circulation passage 5 (closer to the one end) than the first expansion valve 5c, and a main passage 18 having one end to which the first branch passage 16 and the second branch passage 17 are connected and another end to which the compressor 2 is connected. In addition, the cooling passage 15 includes an injection valve 18a in the main passage 18 so that a portion of high-pressure refrigerant that has been caused to be in a liquid phase by being condensed by cooling in the heat exchanger 7 or heating of the thermal load W is diverted from the first circulation passage 5 and is supplied to the compressor 2 after becoming gas-liquid two-phase refrigerant having lower temperature and lower pressure through adiabatic expansion thereof in the injection valve 18a.

Here, the first branch passage 16 includes a first opening/closing control valve 16a constituted by a solenoid valve or the like, the second branch passage 17 includes a second opening/closing control valve 17a constituted by a solenoid valve or the like, and the first and second opening/closing control valves 16a and 17a and the injection valve 18a are electrically connected to the controller 8. In addition, the processor 8 of the controller 8 is capable of selectively shutting off or opening the first branch passage 16 by opening/closing the first opening/closing control valve 16a, selectively shutting off or opening the second branch passage 17 by opening/closing the second opening/closing control valve 17a, and controlling the opening degree of the injection valve 18a.

The first circulation passage 5 is connected at another end thereof to another end of the refrigerant heat exchange passage 7a and includes, as a safety measure, a first emergency shutoff valve 5b, which is constituted by an opening/closing control valve such as a solenoid valve, in the vicinity of the connection port 5a provided at the one end thereof. In addition, similarly, the second circulation passage 6 includes, as a safety measure, a second emergency shutoff valve 6b, which is constituted by an opening/closing switching valve such as a solenoid valve, in the vicinity of the connection port 6a provided at one end thereof similarly. Here, these first and second emergency shutoff valves 5b and 6b are electrically connected to the controller 8 and are brought into an OFF state (closed state) in an emergency such as when, for example, the high-pressure shutoff pressure switch 3c is operated, so that circulation of refrigerant between the temperature regulation device T1 and the thermal load W is stopped by shutting off (in other words, shutting off outflow and inflow of refrigerant from the connection ports 5a and 6a) the flow of refrigerant in the first and second circulation passages 5 and 6. In addition, in the present embodiment, as the first and second emergency shutoff valves 5b and 6b, solenoid valves of a normal close type are used so that the first and second emergency shutoff valves 5b and 6b automatically enter the OFF state at the time of a power outage or the like.

Further, in the heat-dissipating-water circuit 20, the heat-dissipating-water heat exchange passage 21 is arranged along the refrigerant heat exchange passage 7a. Then, the heat-dissipating-water supply/drainage passages 22 and 23 are constituted by a supply passage 22, which is connected to one end of the heat-dissipating-water heat exchange passage 21 and through which heat-dissipating water is supplied to the heat exchanger 7, and a drainage passage 23, which is connected to another end thereof and through which heat-dissipating water after heat exchange is drained from the heat exchanger 7. At this time, when functioning as a condenser (in other words, at the time of cooling of the thermal load W by refrigerant) with refrigerant flowing in the refrigerant heat exchange passage 7a from the compressor 2 side toward the first circulation passage 5 side, the supply passage 22 and the drainage passage 23 for heat-dissipating water are connected to the heat-dissipating-water heat exchange passage 21 so that heat-dissipating water in the heat-dissipating-water heat exchange passage 21 flows in a direction opposite thereto.

Here, the supply passage 22 includes a fourth temperature sensor 22a for detecting a temperature of heat-dissipating water that is to be supplied to the heat exchanger 7, the drainage passage 23 includes a heat-dissipating-water control valve (fifth flow-rate control valve) 23a for regulating the flow rate of heat-dissipating water that is to be supplied to the heat exchanger 7, and the fourth temperature sensor 22a and the fifth flow-rate control valve 23a are electrically connected to the controller 8. Then, the opening degree of the fifth flow-rate control valve 23a is controlled by the processor 8a of the controller 8 controls, and, consequently, the flow rate of heat-dissipating water that flows in the heat-dissipating-water circuit 20 can be regulated.

Next, operation of the temperature regulation device T1 will be described specifically with Fig. 1 and Fig. 2.

Note that, in Fig. 1 and Fig. 2, the flow-rate control valves with hatching show a substantially closed state or a completely closed state (both states are hereinafter collectively referred to as "closed state"), and the flow-rate control valves without hatching show a substantially opened state or a completely opened state (both states are hereinafter collectively referred to as "opened state"). In addition, the opening/closing control valve with hatching shows an OFF state (closed state), and the opening/closing control valve without hatching shows an ON state (opened state).

Fig. 1 illustrates a state (cooling mode) in which temperature regulation of the thermal load W is performed by cooling. In this cooling mode, the switching circuit 10A is controlled by the processor 8a such that the first flow-rate control valve 11a of the first connection passage 11 enters the "opened state", the second flow-rate control valve 12a of the second connection passage 12 enters the "closed state", the third flow-rate control valve 13a of the third connection passage 13 enters the "opened state", and the fourth flow-rate control valve 14a of the fourth connection passage 14 enters the "closed state". In addition, in the cooling passage 15, the first opening/closing control valve 16a of the first branch passage 16 is controlled to be in the ON state, and the second opening/closing control valve 17a of the second branch passage 17 is controlled to be in the OFF state.

With the switching circuit 10A being thus controlled, gas-phase refrigerant discharged from the compressor 2 and having high temperature and high pressure passes through the delivery passage 3 and the first connection passage 11 successively, is guided to the refrigerant heat exchange passage 7a, becomes liquid-phase refrigerant having high pressure by being condensed by cooling in the heat exchanger 7, and is guided to the first circulation passage 5. Then, a portion of refrigerant guided to the first circulation passage 5 is diverted to the first branch passage 16 of the cooling passage 15 to be guided to the main passage 18, becomes gas-liquid two-phase refrigerant having lower temperature and lower pressure through adiabatic expansion thereof in the injection valve 18a, and is supplied for cooling of the compressor 2. Meanwhile, another remaining portion of refrigerant guided to the first passage 5 becomes gas-liquid two-phase refrigerant having lower temperature and lower pressure through adiabatic expansion thereof in the first expansion valve 5c, is delivered to the thermal load W of the semiconductor manufacturing device S through the one connection port 5a, and is supplied for temperature regulation of the thermal load W by cooling. At this time, the refrigerant takes heat from the thermal load W and becomes gas-phase refrigerant having high temperature and low pressure.

Refrigerant after being thus supplied for temperature regulation of the thermal load W passes through the second circulation passage 6 and the third connection passage successively from the other connection port 6a, is guided to the return passage 4, and is returned to the compressor 2. Then, gas-phase refrigerant caused to have higher temperature and higher pressure by the compressor 2 is discharged again to the delivery passage 3. By repeating such reflux of refrigerant, low-temperature refrigerant for cooling can be supplied to the thermal load W in a circulating manner.

On the other hand, Fig. 2 illustrates a state (heating mode) in which temperature regulation of the thermal load W is performed by heating. In this heating mode, the switching circuit 10A is controlled by the processor 8a such that the first flow-rate control valve 11a of the first connection passage 11 enters the "closed state", the second flow-rate control valve 12a of the second connection passage 12 enters the "opened state", the third flow-rate control valve 13a of the third connection passage 13 enters the "closed state", and the fourth flow-rate control valve 14a of the fourth connection passage 14 enters the "opened state". In addition, in the cooling passage 15, the first opening/closing control valve 16a of the first branch passage 16 is controlled to be in an OFF state, and the second opening/closing control valve 17a of the second branch passage 17 is controlled to be in an ON state.

With the switching circuit 10A being thus controlled, gas-phase refrigerant discharged from the compressor 2 and having high temperature and high pressure passes through the delivery passage 3 and the second connection passage 12 successively and is guided to the second circulation passage 6. Refrigerant guided to the second circulation passage 6 is then delivered to the thermal load W of the semiconductor manufacturing device S through the other connection port 6a and is supplied for temperature regulation of the thermal load W by heating. At this time, the refrigerant is condensed with the heat thereof taken by the thermal load W and becomes liquid-phase refrigerant having low temperature and high pressure.

Refrigerant after being thus supplied for temperature regulation of the thermal load W is introduced into the first circulation passage 5 from the one connection port 5a. A portion of refrigerant guided to the first circulation passage 5 is then diverted to the second branch passage 17 of the cooling passage 15 to be guided to the main passage 18, becomes gas-liquid two-phase refrigerant having lower temperature and lower pressure through adiabatic expansion thereof at the injection valve 18a, and is supplied for cooling of the compressor 2. Meanwhile, another remaining portion of refrigerant guided to the first passage 5 becomes gas-liquid two-phase refrigerant having lower temperature and lower pressure through adiabatic expansion thereof at the first expansion valve 5c and is guided to the refrigerant heat exchange passage 7a, and the refrigerant becomes gas-phase refrigerant having high temperature and low pressure through heating thereof at the heat exchanger 7, is guided to the return passage 4 through the fourth connection passage 14, and is returned to the compressor 2. Then, gas-phase refrigerant caused to have higher temperature and higher pressure by the compressor 2 is discharged again to the delivery passage 3. By repeating such reflux of refrigerant, high-temperature refrigerant for heating can be supplied to the thermal load W in a circulating manner.

At the time of switching from the heating mode illustrated in Fig. 2 to the cooling mode illustrated in Fig. 1 in the refrigeration circuit 1A including such a switching circuit 10A, the processor 8a controls these flow-rate control valves such that the opening degrees of the second flow-rate control valve 12a and the fourth flow-rate control valve 14a gradually decrease continuously and the opening degrees of the first flow-rate control valve 11a and the third flow-rate control valve 13a gradually increase continuously. Consequently, the pressure of refrigerant in the first circulation passage 5 gradually increases, and the flow rate of refrigerant for heating delivered to the thermal load W from the connection port 6a of the second circulation passage 6 gradually decreases. Then, when the second flow-rate control valve 12a and the fourth flow-rate control valve 14a enter the "closed state" and the first flow-rate control valve 11a and the third flow-rate control valve 13a enter the "opened state", the flow direction of the refrigerant is reversed to cause refrigerant for cooling to be delivered to the thermal load W from the connection port 5a of the first circulation passage 5, and the cooling mode is activated.

Conversely, at the time of switching from the cooling mode illustrated in Fig. 1 to the heating mode illustrated in Fig. 2, the processor 8a controls these flow-rate control valves such that the opening degrees of the first flow-rate control valve 11a and the third flow-rate control valve 13a gradually decrease continuously and the opening degrees of the second flow-rate control valve 12a and the fourth flow-rate control valve 14a gradually increase continuously. Consequently, the pressure of refrigerant in the second circulation passage 6 gradually increases and the flow rate of refrigerant for cooling delivered to the thermal load W from the connection port 5a of the first circulation passage 5 gradually decreases. Then, when the first flow-rate control valve 11a and the third flow-rate control valve 13a enter the "closed state" and the second flow-rate control valve 12a and the fourth flow-rate control valve 14a enter the "opened state", the flow direction of the refrigerant is reversed to cause refrigerant for heating to be delivered to the thermal load W from the connection port 6a of the second circulation passage 6, and the heating mode is activated.

Since switching between the cooling mode and the heating mode is thus gradually performed by the four flow-rate control valves continuously in the refrigeration circuit 1A, sudden changes in the pressure and temperature of refrigerant at the thermal load W due to switching of the modes can be suppressed. As a result, sudden expansion and contraction caused in materials constituting the thermal load W by such a sudden change in the pressure or temperature of refrigerant can be suppressed, and it becomes possible to ensure processing accuracy in the semiconductor manufacturing device.

Further, in the temperature regulation device T1 for semiconductor manufacturing device according to the present embodiment, the refrigeration circuit 1A and the heat-dissipating-water circuit 20 of the temperature regulation device T1 are controlled by the processor 8a of the controller 8 as described below on the basis of output results of the various types of sensors and the switch that are described above.

First, on the basis of a temperature of returning refrigerant detected by the first temperature sensor 4a of the return passage 4 and a pressure of the returning refrigerant detected by the first pressure sensor 4b, a degree of superheat of the returning refrigerant is calculated, and, when the degree of superheat of the returning refrigerant is lower than a first set superheat degree in the heating mode, the fifth flow-rate control valve 23a, which is the heat-dissipating-water control valve, is controlled to increase the opening degree thereof and to thereby increase the degree of superheat of returning refrigerant that is returned to the compressor 2 through the return passage 4. Conversely, when the degree of superheat of the refrigerant is higher than a second set superheat degree, the fifth flow-rate control valve 23a is controlled to decrease the opening degree thereof and to thereby decrease the degree of superheat of returning refrigerant that is returned to the compressor 2 through the return passage 4. Here, the second set superheat degree is set to a value equal to or greater than the first set superheat degree.

In addition, when a pressure of delivered refrigerant detected by the second pressure sensor 3b of the delivery passage 3 is higher than a first set pressure in the cooling mode, the fifth flow-rate control valve 23a is controlled to increase the opening degree thereof and to thereby decrease the pressure of refrigerant that is discharged from the compressor 2. Conversely, when the pressure of the delivered refrigerant is lower than a second set pressure, the fifth flow-rate control valve 23a is controlled to decrease the opening degree thereof and to thereby increase the pressure of delivered refrigerant discharged from the compressor 2. Here, the second set pressure is set to a value equal to or less than the first set pressure.

In addition, when a temperature of delivered refrigerant detected by the second temperature sensor 3a of the delivery passage 3 is higher than a first set temperature, the injection valve 18a is controlled to increase the opening degree thereof and to thereby decrease the temperature of the compressor 2 and decrease the temperature of refrigerant discharged from the compressor 2. Conversely, when a temperature of the delivered refrigerant is lower than the second set temperature, the injection valve 18a is controlled to decrease the opening degree thereof and to thereby increase the temperature of the compressor 2 and increase the temperature of delivered refrigerant discharged from the compressor 2. Here, the second set temperature is set to a value equal to or less than the first set temperature.

In addition, when a temperature of the thermal load W detected by the third temperature sensor 30 is higher than a first thermal-load set temperature in the cooling mode, the first expansion valve 5c is controlled to increase the opening degree thereof and to thereby decrease the temperature of the thermal load W. Conversely, when a temperature of the thermal load W is lower than a second thermal-load set temperature, the first expansion valve 5c is controlled to decrease the opening degree thereof and to thereby increase the temperature of the thermal load W. Here, the second thermal-load set temperature is set to a value equal to or less than the first thermal-load set temperature.

Further, when the degree of superheat of returning refrigerant that flows in the return passage 4 is lower than a third set superheat degree in the heating mode, the first expansion valve 5c is controlled to decrease the opening degree thereof and to thereby increase the degree of superheat of returning refrigerant that is returned to the compressor 2 through the return passage 4. Conversely, when the degree of superheat of returning refrigerant in the return passage 4 is higher than a fourth set superheat degree, the first expansion valve 5c is controlled to increase the opening degree thereof and to thereby decrease the degree of superheat of returning refrigerant that is returned to the compressor 2 through the return passage 4. Here, the fourth set superheat degree is set to a value equal to or greater than the third set superheat degree. Note that the third set superheat degree may have the same value as the first set superheat degree and the fourth set superheat degree may have the same value as the second set superheat degree. In addition, values of these first to fourth set superheat degrees may be all equal to each other.

Next, a second embodiment of the temperature regulation device for semiconductor manufacturing device according to the present invention will be described on the basis of Fig. 3 and Fig. 4. Note that the same constituent parts as the temperature regulation device T1 in the first embodiment and effects along with the constituent parts are not described here to avoid duplicated description by giving the same signs thereto in the figures basically.

Main differences between a temperature regulation device T2 in this second embodiment and the temperature regulation device T1 in the first embodiment are configurations of switching circuits and presence/absence of a bypass passage 9 that connects the switching circuit 10B directly to the first circulation passage 5.

The switching circuit 10B in the temperature regulation device T2 of the second embodiment includes a four-way switch control valve 40 that is electrically connected to the controller 8, a fifth connection passage 41 that connects the four-way switch control valve 40 to the heat exchanger 7, and a sixth connection passage 42 that connects the four-way switch control valve 40 to the return passage 4. Here, the four-way switch control valve 40 has a first port 40a, a second port 40b, a third port 40c, and a fourth port 40d. Then, the other end of the delivery passage 3 is connected to the first port 40a, one end of the fifth connection passage 41 is connected to the second port 40b with another end thereof connected to the one end of the refrigerant heat exchange passage 7a, one end of the sixth connection passage 42 is connected to the third port 40c with another end thereof connected to the other end of the return passage 4, and the other end of the second circulation passage 6 is connected to the fourth port 40d.

In addition, the four-way switch control valve 40 is configured to be selectively switchable by the processor 8a between a first switched state in which the first port 40a and the second port 40b are in communication with each other and the third port 40c and the fourth port 40d are in communication with each other and a second switched state in which the first port 40a and the fourth port 40d are in communication with each other and the second port 40b and the third port 40c are in communication with each other.

Further, one end side of the bypass passage 9 is branched from the fifth connection passage 41, and another end thereof is connected to the first circulation passage 5 at a location that is closer to the connection port 5a than the first expansion valve 5c and that is also closer to the first expansion valve 5c than the first emergency shutoff valve 5b. In addition, the bypass passage 9 is provided with a second expansion valve 9a that adiabatically expands refrigerant that flows in the passage. The second expansion valve 9a is electrically connected to the controller 8 so that the opening degree thereof can be controlled by the processor 8a of the controller 8.

According to the temperature regulation device T2 having such a configuration, it is possible to selectively switch the mode to the cooling mode (Fig. 3), in which temperature regulation of the thermal load W is performed by cooling, or to the heating mode (Fig. 4), in which temperature regulation of the thermal load W is performed by heating, by the processor 8a controlling the switching circuit 10B to change the communication state in which the first and second circulation passages 5 and 6 are in communication with the delivery passage 3 and the return passage 4. Specifically, by the processor 8a controlling the four-way switch control valve 40 of the switching circuit 10B to be selectively switched to the first switched state or to the second switched state, it is possible to selectively switch the mode between the cooling mode, in which the delivery passage 3 and the first circulation passage 5 are in communication with each other and the second circulation passage 6 and the return passage 4 are in communication with each other, and the heating mode, in which the delivery passage 3 and the second circulation passage 6 are in communication with each other and the first circulation passage 5 and the return passage 4 are in communication with each other.

Next, operation of the temperature regulation device T2 will be described specifically with Fig. 3 and Fig. 4.

Note that, in Fig. 3 and Fig. 4, the opening/closing control valve with hatching shows an OFF state (closed state), and the opening/closing control valve without hatching shows an ON state (opened state).

Fig. 3 illustrates an operation state in the cooling mode in the present embodiment. In the cooling mode, the four-way switch control valve 40 of the switching circuit 10B has been switched by the processor 8a to the first switched state. In addition, in the cooling passage 15, the first opening/closing control valve 16a of the first branch passage 16 is controlled to be in the ON state, and the second opening/closing control valve 17a of the second branch passage 17 is controlled to be switched to the OFF state.

With the four-way switch control valve 40 being thus switched to the first switched state, gas-phase refrigerant discharged from the compressor 2 and having high temperature and high pressure passes through the delivery passage 3 and the fifth connection passage 41 successively to be guided to the heat exchanger 7, is condensed by being cooled in the heat exchanger 7, and is guided to the first circulation passage 5. At this time, a portion of refrigerant is diverted from the fifth connection passage 41 to the bypass passage 9, becomes gas-phase refrigerant having high temperature and low pressure through adiabatic expansion thereof at the second expansion valve 9a, and is then directly introduced into the first circulation passage 5. Meanwhile, as in the first embodiment, a portion of refrigerant guided to the first circulation passage 5 through the heat exchanger 7 is supplied for cooling of the compressor 2 through the cooling passage 15. In addition, another remaining portion of refrigerant is adiabatically expanded at the first expansion valve 5c, is then delivered together with refrigerant in the bypass passage 9 to the thermal load W through the one connection port 5a, and is supplied for temperature regulation of the thermal load W by cooling.

Refrigerant after being thus supplied for temperature regulation of the thermal load W passes through the second circulation passage 6 and the sixth connection passage 42 successively from the other connection port 6a, is guided to the return passage 4, and is returned to the compressor 2. Then, gas-phase refrigerant caused to have higher temperature and higher pressure by the compressor 2 is discharged again to the delivery passage 3. By repeating such reflux of refrigerant, low-temperature refrigerant for cooling can be supplied to the thermal load W in a circulating manner.

Next, Fig. 4 illustrates an operation state in the heating mode in the present embodiment. In the heating mode, the four-way switch control valve 40 of the switching circuit 10B has been switched by the processor 8a to the second switched state. In addition, in the cooling passage 15, the first opening/closing control valve 16a of the first branch passage 16 is controlled to be in the OFF state, and the second opening/closing control valve 17a of the second branch passage 17 is controlled to be switched to the ON state.

With the four-way switch control valve 40 being thus switched to the second switched state, gas-phase refrigerant discharged from the compressor 2 and having high temperature and high pressure is guided to the delivery passage 3 the second circulation passage 6. Refrigerant guided to the second circulation passage 6 is then delivered to the thermal load W through the other connection port 6a and is supplied for temperature regulation of the thermal load W by heating.

Refrigerant after being thus supplied for temperature regulation of the thermal load W is introduced into the first circulation passage 5 from the one connection port 5a. Then, a portion of refrigerant guided to the first circulation passage 5 is first diverted to the bypass passage 9, becomes gas-liquid two-phase refrigerant having low temperature and low pressure through adiabatic expansion thereof at the second expansion valve 9a, and is then directly introduced into the fifth connection passage 41. Subsequently, part of a remaining portion thereof is supplied for cooling of the compressor 2 through the cooling passage 15 as in the first embodiment. Meanwhile, another remaining portion of refrigerant guided to the first passage 5 is adiabatically expanded at the first expansion valve 5c, is then guided to the heat exchanger 7, and evaporates through heating thereof at the heat exchanger 7.

The evaporated refrigerant then passes together with refrigerant in the bypass passage 9 through the fifth connection passage 41 and the sixth connection passage 42 to be guided to the return passage 4 and is returned to the compressor 2. Refrigerant caused to have higher temperature and higher pressure by the compressor 2 is discharged again to the delivery passage 3. By repeating such reflux of refrigerant, high-temperature refrigerant for heating can be supplied to the thermal load W in a circulating manner. Note that, although refrigerant that is directly introduced into the fifth connection passage 41 through the bypass passage 9 is in a gas-liquid two-phase as described above and contains liquid, the liquid evaporates by being mixed with gas-phase refrigerant that is guided to the fifth connection passage 41 through the heat exchanger 7 and that has high temperature and low pressure.

Here, when a pressure of returning refrigerant detected by the first pressure sensor 4b of the return passage 4 is lower than a third set pressure in the cooling mode and the heating mode, the second expansion valve 9a is controlled to increase the opening degree thereof and to thereby increase the pressure of refrigerant in the return passage 4. Conversely, when a pressure of the returning refrigerant is higher than a fourth set pressure, the second expansion valve 9a is controlled to decrease the opening degree thereof and to thereby decrease the pressure of refrigerant in the return passage 4. Here, the fourth set pressure is set to a value equal to or greater than the third set pressure.

Note that the third set pressure may have the same value as the first set pressure and the fourth set pressure may have the same value as the second set pressure. In addition, values of these first to fourth set pressures may be all equal to each other.

### Reference Signs List

T1, T2 temperature regulation device for semiconductor manufacturing device
1A, 1B refrigeration circuit
2 refrigeration compressor
3 delivery passage
3a second temperature sensor
3b second pressure sensor
3c high-pressure shutoff pressure switch
4 return passage
4a first temperature sensor
4b first pressure sensor
5 first circulation passage
5b first emergency shutoff valve
5c first expansion valve
6 second circulation passage
6b second emergency shutoff valve
5a, 6a connection port
7 heat exchanger
7a refrigerant heat exchange passage
8 controller
8a processor
9 bypass passage
9a second expansion valve
10A, 10B switching circuit
11 first connection passage
11a first flow-rate control valve
12 second connection passage
12a second flow-rate control valve
13 third connection passage
13a third flow-rate control valve
14 fourth connection passage
14a fourth flow-rate control valve
15 cooling passage
16 first branch passage
16a first opening/closing control valve
17 second branch passage
17a second opening/closing control valve
18 main passage
18a injection valve
20 heat-dissipating-water circuit
21 heat-dissipating-water heat exchange passage
22 supply passage
22a fourth temperature sensor
23 drainage passage
23a fifth flow-rate control valve (heat-dissipating-water control valve)
30 third temperature sensor
40 four-way switch control valve
40a first port
40b second port
40c third port
40d fourth port
41 fifth connection passage
42 sixth connection passage
W thermal load
S semiconductor manufacturing device

## Claims

1. A temperature regulation device for semiconductor manufacturing device, the temperature regulation device being for regulating a temperature of a thermal load in a semiconductor manufacturing device to a predetermined temperature, the temperature regulation device comprising:
a refrigeration circuit including a refrigeration compressor that generates refrigerant having high temperature and high pressure, a delivery passage connected to the compressor and through which refrigerant is delivered from the compressor, a return passage connected to the compressor and through which refrigerant is returned to the compressor, a first circulation passage and a second circulation passage each having a connection port to be connected to the thermal load and each being for supplying refrigerant to the thermal load in a circulating manner, a switching circuit that mutually switches, between the first and second circulation passages, a circulation passage for delivering refrigerant to the thermal load and a circulation passage for receiving refrigerant from the thermal load by changing a communication state in which the first and second circulation passages are in communication with the delivery passage and the return passage, and a heat exchanger including a refrigerant heat exchange passage that connects the first circulation passage to the switching circuit;
a heat-dissipating-water circuit including a heat-dissipating-water heat exchange passage through which heat-dissipating water that exchanges heat with refrigerant in the refrigerant heat exchange passage in the heat exchanger flows and a heat-dissipating-water supply/drainage passage through which heat-dissipating water is supplied to and drained from the heat-dissipating-water heat exchange passage; and
a controller including a processor that controls the refrigeration circuit and the heat-dissipating-water circuit,
wherein the first circulation passage includes an expansion valve that adiabatically expands refrigerant, and
wherein the processor controls the switching circuit such that, when temperature regulation of the thermal load is performed by cooling, refrigerant is delivered to the thermal load from the connection port of the first circulation passage and refrigerant from the thermal load is received through the connection port of the second circulation passage and conversely, when temperature regulation of the thermal load is performed by heating, refrigerant is delivered to the thermal load from the connection port of the second circulation passage and refrigerant from the thermal load is received through the connection port of the first circulation passage.

2. The temperature regulation device for semiconductor manufacturing device according to claim 1,
wherein the switching circuit includes a first connection passage including a first flow-rate control valve and connecting the delivery passage to the heat exchanger, a second connection passage including a second flow-rate control valve and connecting the delivery passage to the second circulation passage, a third connection passage including a third flow-rate control valve and connecting the second circulation passage to the return passage, and a fourth connection passage including a fourth flow-rate control valve and connecting the heat exchanger to the return passage, and
wherein the processor controls the first to fourth flow-rate control valves such that, when temperature regulation of the thermal load is switched from heating to cooling, refrigerant is delivered to the thermal load from the connection port of the first circulation passage by continuously decreasing an opening degree of the second flow-rate control valve and an opening degree of the fourth flow-rate control valve and continuously increasing an opening degree of the first flow-rate control valve and an opening degree of the third flow-rate control valve and, conversely, when temperature regulation of the thermal load is switched from cooling to heating, refrigerant is delivered to the thermal load from the connection port of the second circulation passage by continuously decreasing an opening degree of the first flow-rate control valve and an opening degree of the third flow-rate control valve and continuously increasing an opening degree of the second flow-rate control valve and an opening degree of the fourth flow-rate control valve.

3. vice for semiconductor manufacturing device according to claim 1,
wherein the return passage includes a first temperature sensor and a first pressure sensor, and the heat-dissipating-water supply/drainage passage includes a heat-dissipating-water control valve, and
wherein the processor calculates a degree of superheat of refrigerant based on a temperature of refrigerant detected by the first temperature sensor and a pressure of refrigerant detected by the first pressure sensor and controls the heat-dissipating-water control valve such that, in a state in which temperature regulation of the thermal load is performed by heating, when a degree of superheat of the refrigerant is lower than a first set superheat degree, an opening degree of the heat-dissipating-water control valve is increased and, conversely, when a degree of superheat of the refrigerant is higher than a second set superheat degree that is equal to or greater than the first set superheat degree, an opening degree of the heat-dissipating-water control valve is decreased.

4. The temperature regulation device for semiconductor manufacturing device according to claim 1,
wherein the delivery passage includes a second pressure sensor, and the heat-dissipating-water supply/drainage passage includes a heat-dissipating-water control valve, and
wherein the processor controls the heat-dissipating-water control valve such that, in a state in which temperature regulation of the thermal load is performed by cooling, when a pressure of refrigerant detected by the second pressure sensor is higher than a first set pressure, an opening degree of the heat-dissipating-water control valve is increased and, conversely, when a pressure of the refrigerant is lower than a second set pressure that is equal to or less than the first set pressure, an opening degree of the heat-dissipating-water control valve is decreased.

5. The temperature regulation device for semiconductor manufacturing device according to any one of claims 1 to 4,
wherein a cooling passage through which refrigerant for compressor cooling is supplied to the compressor is branched from the first circulation passage and connected to the compressor.

6. The temperature regulation device for semiconductor manufacturing device according to claim 5,
wherein the cooling passage includes a first branch passage that is branched from a location closer than the expansion valve to the heat exchanger and that includes a first opening/closing control valve, a second branch passage that is branched from a location closer than the expansion valve to the connection port of the first circulation passage and that includes a second opening/closing control valve, and an injection valve that adiabatically expands refrigerant, the first branch passage and the second branch passage being connected to the compressor through the injection valve, and
wherein the processor controls the first and second opening/closing control valves such that, in a state in which temperature regulation of the thermal load is performed by cooling, the first opening/closing control valve is opened and the second opening/closing control valve is closed and, conversely, in a state in which temperature regulation of the thermal load is performed by heating, the first opening/closing control valve is closed and the second opening/closing control valve is opened.

7. The temperature regulation device for semiconductor manufacturing device according to claim 6,
wherein the delivery passage includes a second temperature sensor that detects a temperature of refrigerant that is delivered from the compressor, and
wherein the processor controls the injection valve such that, when a temperature of refrigerant detected by the second temperature sensor is higher than a first set temperature, an opening degree of the injection valve is increased and, conversely, when a temperature of the refrigerant is lower than a second set temperature that is equal to or less than the first set temperature, an opening degree of the injection valve is decreased.

8. The temperature regulation device for semiconductor manufacturing device according to any one of claims 1 to 4,
wherein the first and second circulation passages each include an emergency shutoff valve that intercepts, in an emergency, inflow and outflow of refrigerant from the connection ports of the circulation passages, and
wherein the emergency shutoff valve is a solenoid valve of a normal close type.

9. The temperature regulation device for semiconductor manufacturing device according to any one of claims 1 to 4,
wherein the temperature regulation device includes a third temperature sensor for detecting a temperature of the thermal load, and
wherein the processor controls the expansion valve such that, in a state in which temperature regulation of the thermal load is performed by cooling, when a temperature of the thermal load detected by the third temperature sensor is higher than a first thermal-load set temperature, an opening degree of the expansion valve is increased and, conversely, when a temperature of the thermal load is lower than a second thermal-load set temperature that is equal to or less than the first thermal-load set temperature, an opening degree of the expansion valve is decreased.

10. The temperature regulation device for semiconductor manufacturing device according to any one of claims 1 to 4,
wherein the return passage includes a first temperature sensor and a first pressure sensor, and
wherein the processor calculates a degree of superheat of refrigerant based on a temperature of refrigerant detected by the first temperature sensor and a pressure of refrigerant detected by the first pressure sensor and controls the expansion valve such that, in a state in which temperature regulation of the thermal load is performed by heating, when a degree of superheat of the refrigerant is lower than a third set superheat degree, an opening degree of the expansion valve is and, conversely, when a degree of superheat of the refrigerant is higher than a fourth set that is equal to or greater than the third set superheat degree, an opening degree of the expansion valve is.

## Amended claims

### Amended claims under Art. 19.1 PCT

1. A temperature regulation device for semiconductor manufacturing device, the temperature regulation device being for regulating a temperature of a thermal load in a semiconductor manufacturing device to a predetermined temperature, the temperature regulation device comprising:
a refrigeration circuit including a refrigeration compressor that generates refrigerant having high temperature and high pressure, a delivery passage connected to the compressor and through which refrigerant is delivered from the compressor, a return passage connected to the compressor and through which refrigerant is returned to the compressor, a first circulation passage and a second circulation passage each having a connection port to be connected to the thermal load and each being for supplying refrigerant to the thermal load in a circulating manner, a switching circuit that mutually switches, between the first and second circulation passages, a circulation passage for delivering refrigerant to the thermal load and a circulation passage for receiving refrigerant from the thermal load by changing a communication state in which the first and second circulation passages are in communication with the delivery passage and the return passage, and a heat exchanger including a refrigerant heat exchange passage that connects the first circulation passage to the switching circuit;
a heat-dissipating-water circuit including a heat-dissipating-water heat exchange passage through which heat-dissipating water that exchanges heat with refrigerant in the refrigerant heat exchange passage in the heat exchanger flows and a heat-dissipating-water supply/drainage passage through which heat-dissipating water is supplied to and drained from the heat-dissipating-water heat exchange passage; and
a controller including a processor that controls the refrigeration circuit and the heat-dissipating-water circuit,
wherein the first circulation passage includes an expansion valve that adiabatically expands refrigerant, and
wherein the processor controls the switching circuit such that, when temperature regulation of the thermal load is performed by cooling, refrigerant is delivered to the thermal load from the connection port of the first circulation passage and refrigerant from the thermal load is received through the connection port of the second circulation passage and conversely, when temperature regulation of the thermal load is performed by heating, refrigerant is delivered to the thermal load from the connection port of the second circulation passage and refrigerant from the thermal load is received through the connection port of the first circulation passage.

2. The temperature regulation device for semiconductor manufacturing device according to claim 1,
wherein the switching circuit includes a first connection passage including a first flow-rate control valve and connecting the delivery passage to the heat exchanger, a second connection passage including a second flow-rate control valve and connecting the delivery passage to the second circulation passage, a third connection passage including a third flow-rate control valve and connecting the second circulation passage to the return passage, and a fourth connection passage including a fourth flow-rate control valve and connecting the heat exchanger to the return passage, and
wherein the processor controls the first to fourth flow-rate control valves such that, when temperature regulation of the thermal load is switched from heating to cooling, refrigerant is delivered to the thermal load from the connection port of the first circulation passage by continuously decreasing an opening degree of the second flow-rate control valve and an opening degree of the fourth flow-rate control valve and continuously increasing an opening degree of the first flow-rate control valve and an opening degree of the third flow-rate control valve and, conversely, when temperature regulation of the thermal load is switched from cooling to heating, refrigerant is delivered to the thermal load from the connection port of the second circulation passage by continuously decreasing an opening degree of the first flow-rate control valve and an opening degree of the third flow-rate control valve and continuously increasing an opening degree of the second flow-rate control valve and an opening degree of the fourth flow-rate control valve.

3. The temperature regulation device for semiconductor manufacturing device according to claim 1,
wherein the return passage includes a first temperature sensor and a first pressure sensor, and the heat-dissipating-water supply/drainage passage includes a heat-dissipating-water control valve, and
wherein the processor calculates a degree of superheat of refrigerant based on a temperature of refrigerant detected by the first temperature sensor and a pressure of refrigerant detected by the first pressure sensor and controls the heat-dissipating-water control valve such that, in a state in which temperature regulation of the thermal load is performed by heating, when a degree of superheat of the refrigerant is lower than a first set superheat degree, an opening degree of the heat-dissipating-water control valve is increased and, conversely, when a degree of superheat of the refrigerant is higher than a second set superheat degree that is equal to or greater than the first set superheat degree, an opening degree of the heat-dissipating-water control valve is decreased.

4. The temperature regulation device for semiconductor manufacturing device according to claim 1,
wherein the delivery passage includes a second pressure sensor, and the heat-dissipating-water supply/drainage passage includes a heat-dissipating-water control valve, and
wherein the processor controls the heat-dissipating-water control valve such that, in a state in which temperature regulation of the thermal load is performed by cooling, when a pressure of refrigerant detected by the second pressure sensor is higher than a first set pressure, an opening degree of the heat-dissipating-water control valve is increased and, conversely, when a pressure of the refrigerant is lower than a second set pressure that is equal to or less than the first set pressure, an opening degree of the heat-dissipating-water control valve is decreased.

5. The temperature regulation device for semiconductor manufacturing device according to any one of claims 1 to 4,
wherein a cooling passage through which refrigerant for compressor cooling is supplied to the compressor is branched from the first circulation passage and connected to the compressor.

6. The temperature regulation device for semiconductor manufacturing device according to claim 5,
wherein the cooling passage includes a first branch passage that is branched from a location closer than the expansion valve to the heat exchanger and that includes a first opening/closing control valve, a second branch passage that is branched from a location closer than the expansion valve to the connection port of the first circulation passage and that includes a second opening/closing control valve, and an injection valve that adiabatically expands refrigerant, the first branch passage and the second branch passage being connected to the compressor through the injection valve, and
wherein the processor controls the first and second opening/closing control valves such that, in a state in which temperature regulation of the thermal load is performed by cooling, the first opening/closing control valve is opened and the second opening/closing control valve is closed and, conversely, in a state in which temperature regulation of the thermal load is performed by heating, the first opening/closing control valve is closed and the second opening/closing control valve is opened.

7. The temperature regulation device for semiconductor manufacturing device according to claim 6,
wherein the delivery passage includes a second temperature sensor that detects a temperature of refrigerant that is delivered from the compressor, and
wherein the processor controls the injection valve such that, when a temperature of refrigerant detected by the second temperature sensor is higher than a first set temperature, an opening degree of the injection valve is increased and, conversely, when a temperature of the refrigerant is lower than a second set temperature that is equal to or less than the first set temperature, an opening degree of the injection valve is decreased.

8. The temperature regulation device for semiconductor manufacturing device according to any one of claims 1 to 4,
wherein the first and second circulation passages each include an emergency shutoff valve that intercepts, in an emergency, inflow and outflow of refrigerant from the connection ports of the circulation passages, and
wherein the emergency shutoff valve is a solenoid valve of a normal close type.

9. The temperature regulation device for semiconductor manufacturing device according to any one of claims 1 to 4,
wherein the temperature regulation device includes a third temperature sensor for detecting a temperature of the thermal load, and
wherein the processor controls the expansion valve such that, in a state in which temperature regulation of the thermal load is performed by cooling, when a temperature of the thermal load detected by the third temperature sensor is higher than a first thermal-load set temperature, an opening degree of the expansion valve is increased and, conversely, when a temperature of the thermal load is lower than a second thermal-load set temperature that is equal to or less than the first thermal-load set temperature, an opening degree of the expansion valve is decreased.

10. (Amended) The temperature regulation device for semiconductor manufacturing device according to any one of claims 1 to 4,
wherein the return passage includes a first temperature sensor and a first pressure sensor, and
wherein the processor calculates a degree of superheat of refrigerant based on a temperature of refrigerant detected by the first temperature sensor and a pressure of refrigerant detected by the first pressure sensor and controls the expansion valve such that, in a state in which temperature regulation of the thermal load is performed by heating, when a degree of superheat of the refrigerant is lower than a third set superheat degree, an opening degree of the expansion valve is decreased and, conversely, when a degree of superheat of the refrigerant is higher than a fourth set superheat degree that is equal to or greater than the third set superheat degree, an opening degree of the expansion valve is increased.

Statement under Art. 19.1 PCT
The amendment to claim 10 is an amendment for the purpose of correcting a clerical error.
